(19) Europäisches Patentamt
European Patent Office
Office européen des brevets

(11) EP 0 524 756 B1

(12) **EUROPEAN PATENT SPECIFICATION**

(45) Date of publication and mention
of the grant of the patent:
**08.04.1998 Bulletin 1998/15**

(51) Int Cl.$^6$: **H04L 25/30**, H03M 13/00

(21) Application number: **92306394.5**

(22) Date of filing: **13.07.1992**

(54) **Iterative sequence estimation technique**

Iteratives Verfahren zur Folgeschätzung

Procédé itératif d'estimation de séquence

(84) Designated Contracting States:
**DE FR GB NL SE**

(30) Priority: **20.07.1991 GB 9115748**

(43) Date of publication of application:
**27.01.1993 Bulletin 1993/04**

(73) Proprietor: **NORTHERN TELECOM LIMITED**
**Montreal, Quebec H2Y 3Y4 (CA)**

(72) Inventor: **Hudson, John Edward**
**Stansted, Essex CM24 8LR (GB)**

(74) Representative: **Ryan, John Peter William et al**
**Nortel Patents,**
**London Road**
**Harlow, Essex CM17 9NA (GB)**

(56) References cited:
**EP-A- 0 332 290**

## Description

This invention relates to a method of decoding a digital signal modulation sequence received over a potentially noisy channel wherein an estimated or reference signal sequence is generated and compared with the received signal sequence whereby to determine the most probable value of the received signal. The invention further relates to a signal processor and a communications apparatus employing the decoding technique.

Such a concept is known from document EP-A-0 332 290.

Digital transmission techniques are finding increasing applications e.g. for the transmission of signals in a personal communications network (PCN). A particular problem that has been experienced is that of corruption of transmitter signal by noise. This noise can arise either from general background noise or from co-channel interference. The effect of this noise is to introduce and element of uncertainty as to whether a particular bit being received represents a ONE or a ZERO. This problem is fundamental to modern digital communication systems where partial signalling and intersymbol interference produced by the transmission medium must be corrected.

This problem has been addressed by a number of techniques the most important of which are discussed below.

The least sophisticated approach to the problem is that of the exhaustive search. This technique is applicable to finite duration data bursts of L symbols, each symbol being selected from an alphabet or set of M (typically 2) values. These are thus $M^L$ possible data sequences with which a received signal sequence may be compared to determine which sequence is coherent to the received sequence in some defined sense. In the presence of additive Gaussian noise the Euclidean metric,

$$D = \sqrt{\Sigma(r_i - S_i)^2}$$

where $r_i$ is the observed sample sequence and $S_i$ is the hypothe ised or proposed sequence, is an appropriate measure of the difference between received and proposed data sequence. Selecting the proposed sequence with the smallest Euclidean distance D' from the received signal is then equivalent to choosing the sequence most likely to give rise to the observed data. The method provides a high degree of accuracy, but it suffers from the disadvantage of a very heavy computation load which, for long data sequences, may be wholly impractical.

In an attempt to reduce the inherent computational load of the exhaustive search, many workers have employed a statistical technique introduced by Viterbi, and commonly known as the Viterbi algorithm. The technique is applicable to a modulating scheme in which the modulating bits have an influence over a finite span of the received sequence. The algorithm then involves an exhaustive search only of bit sequences equal to this span length which is of course much shorter than the complete data sequence. The algorithm selects the most likely bit sequence and rejects the least likely over the span length. Thus, by effectively reducing the total number of possible bit sequences as the calculation proceeds, a significant reduction in the computational load is achieved. There is of course an inaccuracy that is inherent in any statistical method, but this is generally small and this is an acceptable price to pay for the reduction in computational load which, although still high, is at least practicable.

Whilst the Viterbi technique represents a very significant step forward in signal processing, its computation load still requires a significant processor power. This has constrained the introduction of the technique to personal communications networks using portable and hand-held transceivers which are limited in physical size and in available battery power.

The object of the invention is to minimise or overcome this disadvantage.

According to one aspect of the invention there is provided a method of decoding a digital signal modulation sequence received over a potentially noisy channel wherein an estimated or reference signal sequence is generated and compared with the received signal sequence whereby to determine the most probable value of the received signal, characterised in that the method comprises computing an error function corresponding to the difference between the the estimated or reference sequence and the received signal sequence, selectively perturbing the estimated or reference signal sequence, and recomputing the error function for each perturbed sequence whereby to provide a modified estimated or reference sequence whose difference from the received sequence is such that the error function has a minimum value, and wherein at each perturbation, the error function is recomputed only for the merge length of the two sequences.

According to another aspect of the invention there is provided a signal decoder for decoding a digital signal modulation sequence received over a potentially noisy channel wherein an estimated or reference signal sequence is generated and compared with the received signal sequence whereby to determine the most probable value of the received signal, characterised in that the decoder comprises means for computing an error function corresponding to the difference between the the estimated or reference sequence and the received signal sequence, and means for selectively perturbing the estimated or reference signal sequence and for recomputing the error function for each perturbed sequence for the merge length of the two sequences whereby to provide a modified estimated or reference sequence whose difference from the received sequence is such that the error function has a minimum value.

The technique employs an iterative process to converge on a maximum likelihood sequence from an initial arbitrary guess. The process steps involve perturbing the sequence estimate and measuring the consequent change in error power using a defined metric.

The technique is of particular application, but is by no means limited to systems employing raised cosine or Gaussian minimum shift keying, for example personal communications networks. In such a network, each subscriber has a channel identifier binary code sequence to identify his allocated share of the common channel.

An embodiment of the invention will now be described with reference to the accompanying drawings in which:-

Fig. 1 illustrates a typical signal format; and

Fig. 2 is a schematic diagram of a receiver for decoding a digital signal received over a potentially noisy channel.

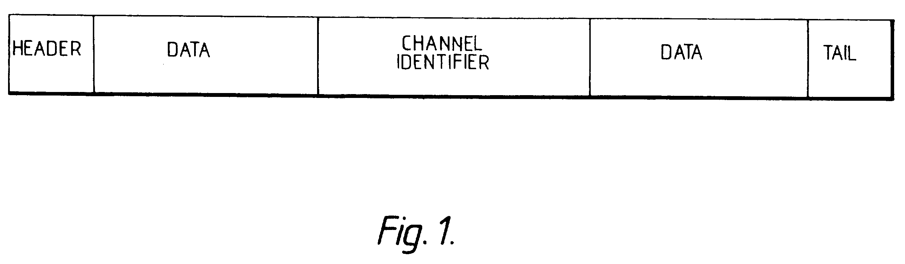

Referring to Fig. 1, a typical transmission burst includes a header portion, first data portion, a channel identifier sequence, a further data portion and a tail portion. In a typical tranmission protocol the data portions are of fifty six bits each and the channel identifier comprises a sequence of twenty six bits chosen from a subset of the $2^{26}$ possible bit sequences.

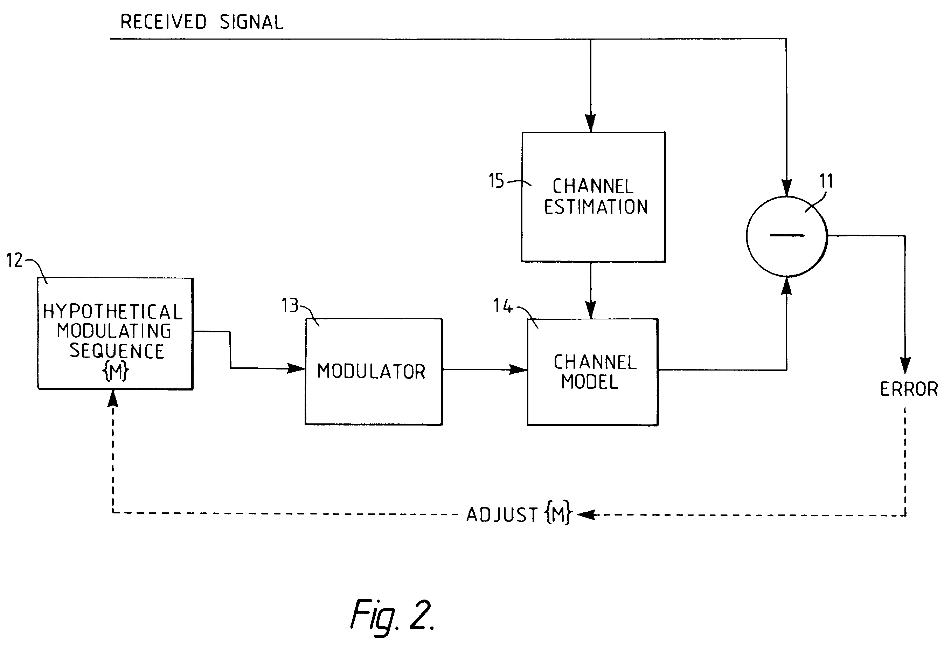

Referring now to Fig. 2, a received digital signal sequence, e.g. a continuous phase modulated sequence representing a series of binary digits, is fed to a subtractor 11 where it is compared with a locally generated estimated binary signal sequence from a generator 12. This estimated sequence modulated on to a carrier by modulator 13 and is then fed via a channel model 14 to the subtractor 11 where it is compared with the received signal. The channel model 14 is controlled via a channel estimator 15 so as to provide the estimated signal with conditions equivalent to those experienced by the received signal over its own transmission channel.

The subtractor 11 compares the received and estimated sequence whereby to determine a measure, e.g. the Euclidean distance, of the difference between them. The estimated sequence is then perturbed and the comparison is repeated to determine the effect of the perturbation. Those perturbations which reduce the Euclidean distance are retained and the process is repeated until a minimum predetermined distance between the two sequences is achieved. The perturbed estimated sequence is then considered to be the most probable signal sequence.

The manner in which the perturbation is effected is described below.

The theory of continuous phase modulation discusses pairs of modulation sequence [a], [b] which are equal up to some time instant "k". diverge for a small number of symbols, then become equal again at some later time "m":

$$a_i = b_i , \qquad i<k$$

$$a_i \neq b_i , \qquad K \leq i \leq m$$

$$a_i = b_i , \qquad i>m$$

certain pairs have the additional property that when passed to a modulator to generate a carrier, the associated carrier phase is equal for i<k and for i>n where n may be greater than m. For such sequences, the number of samples n during which the carrier phases are unequal is called the merge distance.

Let $[s^1]$ and $[s^2]$ be such a pair of modulating sequences. With this pair of sequences is the associated pair of complex carrier sequences $[c^1]$, $[c^2]$ and a Euclidean distance or metric D which measures the difference between them:

$$D^2 = \Sigma_i \left| c_i^1 - C_i^2 \right|^2, \quad i=k,..,k+n$$

The design of the parameters for continuous phase modulation systems is intimately connected with the smallest Euclidean distance for all possible pairs of modulating sequences $D_{min}$ since it can be shown that the error rate in an optimum (maximum likelihood) receiver is related closely to $D_{min}$. In general pairs of sequences with the smallest Euclidean distance also have the shortest merge "m". $D_{min}$ is a function of the modulation index and the shape of the "phase pulse" in the continuous phase digital modulator.

For binary-symbolled GMSK, with a modulation index of 0.5, it has been found that the smallest distance is between pairs of carriers corresponding to modulating sequences like the following:

$$S^1 = xxxxxxxx01xxxxxxxx \qquad (1a)$$

$$S^2 = xxxxxxxx10xxxxxxxx \qquad (1b)$$

where "x" means don't care but equal between $S^1$ and $S^2$. These sequences differ only in two positions and the merge length is 3 samples. Other "close" sequences are:

$$S^3 = xxxxxxxx0x1xxxxxxxxx \qquad (2a)$$

$$S^4 = xxxxxxxx1x0xxxxxxxxx \qquad (2b)$$

$$S^5 = \text{xxxxxxxx00xxxxxxxx} \qquad (3a)$$

$$S^6 = \text{xxxxxxxx11xxxxxxxx} \qquad (3b)$$

$$S^7 = \text{xxxxxxxx0101xxxxxxx} \qquad (4a)$$

$$S^8 = \text{xxxxxxxx1010xxxxxxx} \qquad (4b)$$

$$S^9 = \text{xxxxxxxx0000xxxxxxx} \qquad (5a)$$

$$S^{10} = \text{xxxxxxxx1111xxxxxxx} \qquad (5b)$$

In the case of $S^5$ and $S^6$ the first carrier retards by 180° as a result of the two zeros and the second carrier advances by 180° as a result of the two 1's and after a small interval of time the phases are equal again, merging with a differential phase of 360°. In the case of $S^9$ and $S^{10}$ the first carrier retards by 360° and the second advances by 360° as the modulating sequences pass through the modulator, and they merge with a differential phase of 720°.

In the presence of multipath it cannot be guaranteed that sequences which are smallest distance pairs under under ideal conditions remain as such after distortion by the channel though it appears to be normally the case.

The aim of the iterative perturbation method is to change gradually the estimated modulating sequence one bit at a time such that the error between the estimated carrier sequence and the observed carrier sequence is reduced to a minimum. Since GMSK is inherently a frequency modulation, the effect of a single bit change in the modulating sequence is to cause a change in the carrier phase which extends from the time of the bit to the end of the data burst. With a modulation index of o.5, a change in one bit ultimately causes a reversal of carrier phase and the difference energy between the old and new sequences is proportional to the remaining data burst length. Thus changing modulating bits one at a time creates large differences between associated carriers and is not a suitable method for search.

To produce only small changes in the carrier sequences, the perturbation of the sequences is designed to take the start sequence to its closest pair in the sense defined above and this is done by EXORing the modulating sequence estimate with the sequence

$$0000000110000000 \qquad (6)$$

or the sequence

$$0000000111100000 \qquad (7)$$

The effect of sequence (6) is to convert sequence (1a) into (1b) and vice-versa and (3a) into (3b) and vice-versa while the effect of (2) is to convert sequence (4a) and (4b) and (5a) into (5b) and vice-versa. Sequences with a gap like (2) do not appear to be useful and are included here for comparative purposes.

When the modulating sequence estimate is modified in this way the new error energy at the receiver, is recomputed and if it has reduced the change is accepted, otherwise the old sequence is restored. In view of the short merge of the smallest distance sequences it is not necessary to recompute the whole error energy, only the duration of the merge length needs to be compared. This causes a substantial reduction in computation load.

The way that this technique differs from the Viterbi algorithm is that Viterbi, by the time it has reached the $n^{th}$ bit in the sequence, has effectively considered all possible $2^n$ data sequences and stored the errors, for the most likely ones. In the present algorithm an attempt is made to take out a finite segment of the sequence and optimise the bits in this segment only. The key to achieving this is to use exclusively sequence changes to shortest merge alternatives but it is not possible to achieve complete isolation from one segment to the next and the coupling between segment is corrected by the small number of iterations required by the algorithm.

There are a variety of ways to program the application of the elemental perturbations to the whole data burst, but the most effective has been found to be the following linear slide.

Initially assign the estimated modulation sequence random values $[m_i^1]$ and starting with perturbation sequence (6) at the leftmost position generate the perturbed sequence $[m_1^2]$ and compare the two error powers. Retain the sequence giving the smaller error power.

Slide the position of sequence (6) along one bit and repeat the procedure.

Continue to the L-1 position

Restart at the beginning repeating until no further change is generated.

The error measuring part of this algorithm can be formalised as follows. Let the carrier sequence associated with $[m_1^1]$ be $[S_i^1]$ and let the channel impulse response (of duration L+1) be $C_i$, i=1,..,L. The merge distance of the perturbations in the presence of multipath extending over L+1 bits is L+3 samples. Define $P_k^2$ as the sequence

$$p_k^2 = [0000001100000.......]$$

which has the first set bit at the k-th position and has 2 set bits altogether, and define

$$[m_i^2 = [m_i^1] \text{ XOR } [p_i^2]$$

Given a received sampled data sequence $r_i$, $i=1,...,$N, the comparison algorithm is then as follows:

## Algorithm I

$$\text{FOR } k = 1, N$$

$$D_1 = \sum_k^{k+m} \left| r_i - s_i^1 \right|^2$$

$$[m_i^2] = [m_i^1] \text{ XOR } [p_k]$$

$$D_2 = \sum_k^{k+m} \left| r_i - s_i^2 \right|^2$$

$$\text{IF } D_2 < D_1 \text{ THEN } [m_i^1] = [m_i^2]$$

## ENDLOOP

Normally two or three sweeps are sufficient to reach the minimum error and, in the absence of multipath, the first sweep will normally determine the correct sequence. In the presence of an extended channel impulse response a minimum error condition is still quickly reached but it may be a false minimum; the exclusive application of the $[p_i^2]$ sequences only cannot guarantee to find the least squares (maximum likelihood) solution.

If the estimate of the modulating sequence were the true minimum square error (MMSE) one, the "optimum" sequence which the Viterbi algorithm would determine, then application of any perturbation to it would increase the error power. Thus, if applying any feasible perturbation to the modulating sequence $[m_i]$ results in an increase in error power, then the modulating sequence $[m_i]$ is the least squares estimate of the transmitted modulating sequence.

It is not desirable to use a large number of different perturbation sequences or use long perturbation sequences to check if the carrier error can be reduced since this increases work load and in the limit, if perturbation sequences as long as the data sequence were used the algorithm would degenerate into a procedure rather close to the Viterbi algorithm. In practice the optimum modulating sequence can be found using only a restricted number of short perturbation sequences. These are dependent on the impulse response of the channel in question.

For the GSM modulation standard using 116-bit data bursts at a rate of 200 per second (23,200 bauds), the estimated work load for a full Viterbi algorithm which computes a look-up table for each data burst, in the absence of multipath, is 2 MFLOPS. With a five-tap channel impulse response it is 35 MFLOPS. For a single application of algorithm I, and in the absence of multipath, the work load for the present method is comparable to that of the Viterbi method.

Various techniques are available to reduce computation load by assigning, to look-up tables, the results of calculations which are likely to be repeated. For example both methods require evaluation of the carrier phase after a sequence of three arbitrary bits combined with an initial carrier phase ambiguous to N /2. The 32 combinations of this state can be preset in a table of 32 entries.

In the presence of multipath the Viterbi work load is doubled for each additional tap of the channel impulse response beyond the first. Thus with a 6-tap CIR work load is $s^5 = 32$ times greater. The present algorithm's work load is increased in two ways:

(i) the computation of the estimated carrier has a greater work load, but this only increases linearly with the number of CIR taps. A six-tap CIR would increase the work load by 8/3 - 2.67 times.
(ii) More iterations are required. With a five tap CIR, six or seven iterations may be required.

Thus overall, beyond a 5 or 6 tap channel impulse response the present algorithm will have a smaller work load than that of a comparable Viterbi algorithm.

The technique is of particular application to portable battery powered transceivers such as are employed in mobile telephony, but the technique may also be employed for signal sequence decoding, e.g. in microwave and optical transmission systems.

## Claims

1. A method of decoding a digital signal modulation sequence received over a potentially noisy channel wherein an estimated or reference signal sequence is generated and compared with the received signal sequence whereby to determine the most probable value of the received signal, characterised in that the method comprises computing an error function corresponding to the difference between the the estimated or reference sequence and the received signal sequence, selectively perturbing the estimated or reference signal sequence, and recomputing the error function for each perturbed sequence whereby to provide a modified estimated or reference sequence whose difference from the received sequence is such that the error function has a minimum value, and wherein at each perturbation, the error function is recomputed only for the merge length of the two sequences.

2. A method as claimed in claim 1, characterised in that the error function corresponds to the Euclidean distance between the two signals.

3. A method as claimed in claim 1 or 2, characterised in that said signal modulation format comprises raised cosine or Gaussian minimum shift keying.

4. A signal decoder for decoding a digital signal modulation sequence received over a potentially noisy channel wherein an estimated or reference signal sequence (12) is generated and compared with the received signal sequence whereby to determine the most probable value of the received signal, characterised in that the decoder comprises means (11) for computing an error function corresponding to the difference between the the estimated or reference sequence and the received signal sequence, and means (13) for selectively perturbing the estimated or reference signal sequence and for recomputing the error function for each perturbed sequence for the merge length of the two sequences whereby to provide a modified estimated or reference sequence whose difference from the received sequence is such that the error function has a minimum value.

5. A signal decoder as claimed in claim 4, characterised in that the error function corresponds to the Euclidean distance between the two signals.

6. A signal decoder as claimed in claim 4 or 5, characterised in that said signal modulation format comprises raised cosine or Gaussian minimum shift keying.

7. Communications apparatus incorporating a signal decoder as claimed in claim 4, 5 or 6.

8. Communications apparatus as claimed in claim 7 and comprising a portable battery powered transceiver.

**Patentansprüche**

1. Verfahren zur Decodierung einer digitalen Signalmodulationsfolge, die über einen möglicherweise gestörten Kanal empfangen wird, wobei eine geschätzte oder Bezugssignalfolge erzeugt und mit der empfangenen Signalfolge verglichen wird, um auf diese Weise den wahrscheinlichsten Wert des empfangenen Signals zu bestimmen, dadurch gekennzeichnet, daß das Verfahren die Berechnung einer Fehlerfunktion entsprechend der Differenz zwischen der geschätzten oder Bezugsfolge und der empfangenen Signalfolge, die selektive Umordnung der geschätzten oder Bezugssignalfolge und die erneute Berechnung der Fehlerfunktion für jede umgeordnete Folge umfaßt, um auf diese Weise eine modifizierte geschätzte oder Bezugsfolge zu schaffen, deren Unterschied gegenüber der empfangenen Folge derart ist, daß die Fehlerfunktion einen Minimalwert hat, und wobei bei jeder Umordnung die Fehlerfunktion lediglich für die Zusammenführungslänge der beiden Folgen erneut berechnet wird.

2. Verfahren nach Anspruch 1, dadurch gekennzeichnet, daß die Fehlerfunktion der euklidischen Entfernung zwischen zwei Signalen entspricht.

3. Verfahren nach Anspruch 1 oder 2, dadurch gekennzeichnet, daß das Signalmodulationsformat eine potenzierte Cosinus- oder Gauß'sche Minimum-Umtastung umfaßt.

4. Signaldecodierer zur Dekodierung einer digitalen Signalmodulationsfolge, die über einen möglicherweise gestörten Kanal empfangen wird, wobei eine geschätzte oder Bezugssignalfolge (12) erzeugt und mit der empfangenen Signalfolge verglichen wird, um den wahrscheinlichsten Wert des empfangenen Signals zu bestimmen, dadurch gekennzeichnet, daß der Decodierer Einrichtungen (11) zur Berechnung einer Fehlerfunktion entsprechend der Differenz zwischen der geschätzten oder Bezugsfolge und der empfangenen Signalfolge und Einrichtungen (13) zum selektiven Umordnen der geschätzten oder Bezugssignalfolge und zur erneuten Berechnung der Fehlerfunktion für jede umgeordnete Folge für die Zusammenführungslänge der beiden Folgen umfaßt, um auf diese Weise eine modifizierte geschätzte oder Bezugsfolge zu schaffen, deren Differenz gegenüber der empfangenen Folge derart ist, daß die Fehlerfunktion einen minimalen Wert hat.

5. Signaldecodierer nach Anspruch 4, dadurch gekennzeichnet, daß die Fehlerfunktion der euklidischen Entfernung zwischen den beiden Signalen entspricht.

6. Signaldecodierer nach Anspruch 4 oder 5, dadurch gekennzeichnet, daß das Signalmodulationsformat eine potenzierte Cosinus- oder Gauß'sche Minimum-Umtastung umfaßt.

7. Nachrichtenübertragungsvorrichtung mit einem Signaldecodierer, wie er in den Ansprüchen 4, 5 oder 6 beansprucht ist.

8. Nachrichtenübertragungsvorrichtung nach Anspruch 7, die einen tragbaren batteriegespeisten Sendeempfänger umfaßt.

## Revendications

1. Procédé de décodage d'une séquence de modulation de signaux numériques recue par un canal potentiellement bruyant, dans lequel une séquence de signaux estimée ou de référence est créée et est comparée à la séquence de signaux reçue pour la détermination de la valeur la plus probable du signal reçu, caractérisé en ce que le procédé comprend le calcul d'une fonction d'erreur qui correspond à la différence entre les séquences estimée ou de référence et la séquence de signaux reçue, la perturbation sélective de la séquence de signaux estimée ou de référence, et le nouveau calcul de la fonction d'erreur pour chaque séquence perturbée de manière qu'une séquence estimée ou de référence modifiée soit formée avec une différence par rapport à la séquence reçue telle que la fonction d'erreur a une valeur minimale, et, à chaque perturbation, la fonction d'erreur est calculée à nouveau uniquement pour la longueur de fusion des deux séquences.

2. Procédé selon la revendication 1, caractérisé en ce que la fonction d'erreur correspond à la distance euclidienne entre les deux signaux.

3. Procédé selon la revendication 1 ou 2, caractérisé en ce que le changement de modulation de signaux est une modulation de fréquence minimale gaussienne ou cosinusoïdale.

4. Décodeur de signaux destiné à décoder une séquence de signaux numériques modulée reçue par un canal potentiellement bruyant, dans lequel une séquence de signaux estimée ou de référence (12) est créée et comparée à la séquence de signaux reçue pour la détermination de la valeur la plus probable du signal reçu, caractérisé en ce que le décodeur comporte un dispositif (11) de calcul d'une fonction d'erreur qui correspond à la différence entre la séquence de signaux estimée ou de référence et la séquence de signaux reçue, et un dispositif (13) de perturbation sélective de la séquence de signaux estimée ou de référence et de recalcul de la fonction d'erreur pour chaque séquence perturbée pour la détermination de la distance de fusion des deux séquences afin qu'une séquence de signaux estimée ou de référence modifiée dont la différence avec la séquence reçue est telle que la fonction d'erreur a une valeur minimale soit réalisée.

5. Décodeur de signaux selon la revendication 4, caractérisé en ce que la fonction d'erreur correspond à la distance euclidienne entre les deux signaux.

6. Décodeur de signaux selon la revendication 4 ou 5, caractérisé en ce que le format de modulation de signaux est un format de modulation minimale gaussienne ou cosinusoïdale.

7. Appareil de communications comprenant un décodeur de signaux selon la revendication 4, 5 ou 6.

8. Appareil de communications selon la revendication 7, comprenant un émetteur-récepteur portatif alimenté par accumulateur.

| HEADER | DATA | CHANNEL IDENTIFIER | DATA | TAIL |
|--------|------|---------------------|------|------|

*Fig. 1.*

Fig. 2.